(19) Europäisches Patentamt
European Patent Office
Office européen des brevets

(11) **EP 2 420 889 A1**

(12) **EUROPEAN PATENT APPLICATION**
published in accordance with Art. 153(4) EPC

(43) Date of publication:
**22.02.2012 Bulletin 2012/08**

(21) Application number: **10764234.0**

(22) Date of filing: **08.04.2010**

(51) Int Cl.:
***G03F 7/004*** *(2006.01)* ***G03F 7/027*** *(2006.01)*
***H01L 21/027*** *(2006.01)*

(86) International application number:
**PCT/JP2010/002562**

(87) International publication number:
**WO 2010/119647 (21.10.2010 Gazette 2010/42)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **14.04.2009 JP 2009097696**

(71) Applicant: **Sumitomo Bakelite Co., Ltd.**
**Shinagawa-ku**
**Tokyo 140-0002 (JP)**

(72) Inventors:
- **SATO, Toshihiro**
  **Tokyo 140-0002 (JP)**
- **KAWATA, Masakazu**
  **Tokyo 140-0002 (JP)**
- **YONEYAMA, Masahiro**
  **Tokyo 140-0002 (JP)**
- **TAKAHASHI, Toyosei**
  **Tokyo 140-0002 (JP)**
- **DEJIMA, Hirohisa**
  **Tokyo 140-0002 (JP)**
- **SHIRAISHI, Fumihiro**
  **Tokyo 140-0002 (JP)**

(74) Representative: **Müller, Christian Stefan Gerd**
**Dr. Volker Vossius**
**Patent- und Rechtsanwaltskanzlei**
**Geibelstrasse 6**
**81679 München (DE)**

# (54) PHOTOSENSITIVE RESIN COMPOSITION, ADHESIVE FILM, AND LIGHT RECEIVING DEVICE

(57) An object of the present invention is to provide a photosensitive resin composition which leaves a small amount of resin residues after patterning by light-exposure and development and can reduce condensation between the semiconductor wafer and the transparent substrate under a high temperature and high humidity environment, an adhesive film made of the photosensitive resin composition and a light-receiving device including the adhesive film. The photosensitive resin composition of the present invention contains an alkali soluble resin (A), a photopolymerization initiator (B) and a compound (C) having a phenolic hydroxyl group and a carboxyl group.

Fig.1

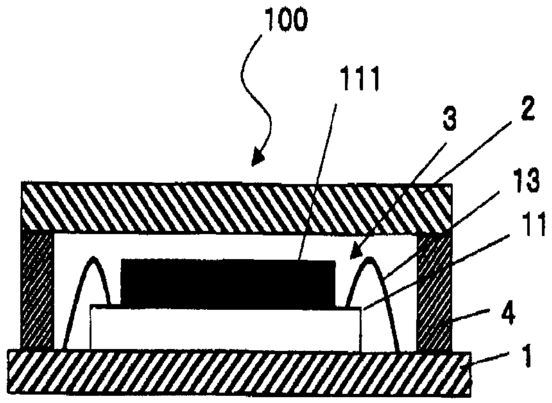


EP 2 420 889 A1

## Description

TECHNICAL FIELD

The present invention relates to a photosensitive resin composition, an adhesive film and a light-receiving device.

BACKGROUND ART

In recent years, a photosensitive film which attaches a transparent substrate such as a glass on a semiconductor wafer, after processes of laminating the photosensitive film on the semiconductor wafer or the like and forming a pattern by light-exposure and development, has been required (for example, see Patent Document 1). When such a photosensitive film is used, the patterned photosensitive film serves as spacer between the semiconductor wafer and the transparent substrate.

RELATED DOCUMENT

[Patent Document 1] Japanese Unexamined patent publication NO. 2006-323089

DISCLOSURE OF THE INVENTION

However, in conventional adhesive films, it has been difficult to reduce both resin residues left after patterning by light-exposure and development and condensation occurring between the semiconductor wafer and the transparent substrate under a high temperature and high humidity environment, when used as a spacer between the semiconductor wafer and the transparent substrate, and it has not been easy to fabricate a semiconductor device with high reliability.
An object of the present invention takes into consideration the aforementioned problems and is to provide a photosensitive resin composition which leaves a small amount of resin residues after patterning by light-exposure and development and can reduce condensation between the semiconductor wafer and the transparent substrate under a high temperature and high humidity environment, when used as a spacer between the semiconductor wafer and the transparent substrate.
This object is accomplished by the present invention mentioned in [1] to [14] below.

[1] A photosensitive resin composition containing: an alkali soluble resin (A); a photopolymerization initiator (B); and a compound (C) having a phenolic hydroxyl group and a carboxyl group.
[2] The photosensitive resin composition mentioned in [1], wherein the compound (C) having a phenolic hydroxyl group and a carboxyl group includes a compound represented by one of general formulae (1) to (3).

[Chemical Formula 1]

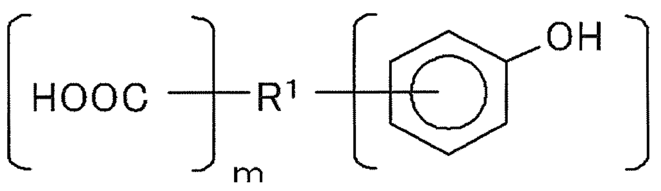
(1)

In formula (1), m and n are an integer of 1 to 3 and $R^1$ represents an organic group. In formula (1), an aromatic ring may have other substituent groups, in addition to a hydroxyl group.

[Chemical Formula 2]

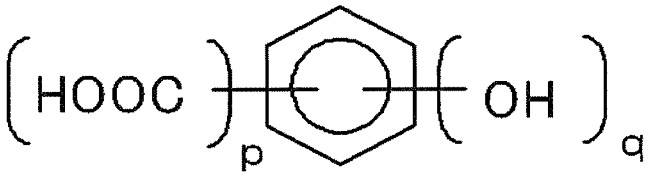

(2)

In formula (2), p and q are an integer of 1 to 5 under the condition that p+q=6. In formula (2), an aromatic ring may have other substituent groups, in addition to a hydroxyl group or a carboxyl group.

[Chemical Formula 3]

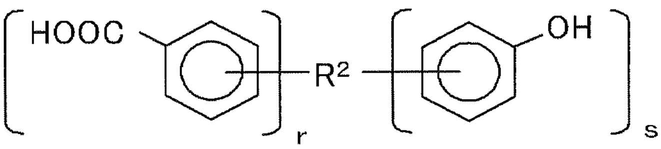

(3)

In formula (3), r and s are an integer of 1 to 3, and $R^2$ represents an organic group, a single bond, -O-, -S-, or $-SO_2-$. In formula (3), an aromatic ring may have other substituent groups, in addition to a hydroxyl group or a carboxyl group.
[3] The photosensitive resin composition mentioned in [1] or [2], wherein the compound (C) having a phenolic hydroxyl group and a carboxyl group has a weight-average molecular weight of 100 to 5000.
[4] The photosensitive resin composition mentioned in any one of [1] to [3], wherein the content of the compound (C) having a phenolic hydroxyl group and a carboxyl group is 0.1 to 30% by weight.
[5] The photosensitive resin composition mentioned in any one of [1] to [4], further containing a thermosetting resin (D).
[6] The photosensitive resin composition mentioned in [5], wherein the content of the thermosetting resin (D) is 10 to 70% by weight.
[7] The photosensitive resin composition mentioned in [5] or [6], wherein the thermosetting resin (D) contains an epoxy resin.
[8] The photosensitive resin composition mentioned in [7], wherein the epoxy resin is at least one selected from the group consisting of phenol novolac-type epoxy resins, cresol novolac-type epoxy resins, dicyclopentadiene-type epoxy resins and trisphenol methane-type epoxy resins.
[9] The photosensitive resin composition mentioned in any one of [1] to [8], further containing a photopolymerizable compound (E) different from the alkali soluble resin (A).
[10] The photosensitive resin composition mentioned in any one of [1] to [9], wherein the alkali soluble resin (A) has an alkali soluble group and a double bond.
[11] The photosensitive resin composition mentioned in any one of [1] to [10], wherein the alkali soluble resin (A) is a (meth) acryloyl-modified phenol resin.
[12] The photosensitive resin composition mentioned in any one of [1] to [11], wherein the photosensitive resin composition is used for forming a spacer of a light-receiving device, wherein the light-receiving device includes: a semiconductor device-mounted substrate; a transparent substrate facing the semiconductor device-mounted substrate; and the spacer provided between the semiconductor device-mounted substrate and the transparent substrate.
[13] An adhesive film made of the photosensitive resin composition mentioned in any one of [1] to [11].
[14] A light-receiving device including: a semiconductor device-mounted substrate; a transparent substrate facing the semiconductor device-mounted substrate; and a spacer provided between the semiconductor device-mounted substrate and the transparent substrate, wherein the spacer is a cured material of the photosensitive resin composition mentioned in any one of [1] to [11].

The present invention provides a photosensitive resin composition which leaves a small amount of resin residues after patterning by light-exposure and development and can reduce condensation between the semiconductor wafer and the transparent substrate under a high temperature and high humidity environment, when used as a spacer between

the semiconductor wafer and the transparent substrate.

BRIEF DESCRIPTION OF DRAWINGS

The above and other objects, features and other advantages of the present invention will be more clearly understood from the following preferred embodiments taken in conjunction with the accompanying drawings.
[FIG. 1] FIG. 1 is a sectional view illustrating a light-receiving device according to one embodiment of the present invention.

DESCRIPTION OF EMBODIMENTS

Hereinafter, preferred embodiments of the photosensitive resin composition, adhesive film and light-receiving device of the present invention will be described with reference to the drawings in detail.

(Photosensitive resin composition)

The photosensitive resin composition of the present invention contains an alkali soluble resin (A). For this reason, selective patterning by light irradiation is possible.
Examples of the alkali soluble resin (A) include novolac resins such as cresol-, phenol-, bisphenol A-, bisphenol F-, catechol-, resorcinol- and pyrogallol-type resins, acryl-based resins such as phenol aralkyl resins, hydroxyl styrene resins, methacrylic acid resins and methacrylic acid ester resins, cyclic olefin-based resins including a hydroxyl group, a carboxyl group or the like, and polyamide-based resins (specifically, resins having at least one of polybenzoxazole structure and polyimide structure, and a hydroxyl, carboxyl, ether or ester group in a main or side chain, resins having a polyimide precursor structure, resins having a polyamide acid ester structure or the like).
In addition, the alkali soluble resin (A) is more preferably a resin having an alkali soluble group and a double bond.
Examples of the resin having an alkali soluble group and a double bond include curable resins which are curable by light and heat.
Examples of the alkali soluble group include hydroxyl and carboxyl groups and the like. The alkali soluble group may contribute to a thermosetting reaction.
Examples of the curable resin include thermosetting resins having photoreactive groups such as acryloyl, methacrylic, vinyl groups and the like and light curable resins having thermoreactive groups such as phenolic hydroxyl groups, alcoholic hydroxyl groups, carboxyl groups, acidic anhydride groups and the like.
The light curable resins may further have thermoreactive groups such as epoxy, amino, cyanate groups and the like. Specifically, examples of the thermosetting resin include (meth)acryl-modified phenol resins, (meth) acryloyl group-containing acrylic acid polymers, carboxyl group-containing (epoxy) acrylate and the like. In addition, the light curable resin may be a thermoplastic resin such as a carboxyl group-containing acryl resin, or a hydroxyl or carboxyl group-containing polyimide resin. The (meth)acryl-modified phenol resin is preferable among these. The use of a resin containing an alkali soluble group enables an alkali aqueous solution having less environmental load to be applied, instead of an organic solvent commonly used as a developing liquid. In addition, a double bond moiety contributes to the curing reaction, thus maintaining heat resistance of the photosensitive resin composition.
When a thermosetting resin having a photoreactive group is used, a modification ratio (substitution ratio) of the photoreactive group is not particularly limited, but is preferably 20 to 80%, particularly preferably 30 to 70%, based on the total amount of the reactive group of the resin having an alkali soluble group and a double bond. By controlling the modification ratio of the photoreactive group within this range, a photosensitive resin composition with considerably high resolution can be provided.
Meanwhile, when a light curable resin having a thermoreactive group is used, a modification ratio (substitution ratio) of the thermoreactive group is not particularly limited, but is preferably 20 to 80%, particularly preferably 30 to 70%, based on the total amount of the reactive group of the resin having an alkali soluble group and a double bond. By controlling the modification ratio of the thermoreactive group to be within this range, a photosensitive resin composition with considerably high resolution can be provided.
The weight-average molecular weight of the resin having an alkali soluble group and a double bond is not particularly limited, but is preferably 300,000 or less, particularly preferably 5,000 to 150,000. When the weight-average molecular weight is within this range, film formation properties are particularly excellent in the process of forming the spacers of the semiconductor device. For example, the weight-average molecular weight may be evaluated using gel permeation chromatography (GPC), calculated by a calibration line previously made using a styrene standard material. In addition, the measurement was carried out at a temperature of 40°C or less using tetrahydrofuran (THF) as a measurement solvent.

The content of the alkali soluble resin (A) is not particularly limited, but is preferably 10 to 80% by weight, particularly preferably 20 to 70% by weight, based on the total weight of the photosensitive resin composition of the present invention. When the content of the alkali soluble resin (A) is adjusted to the lower limit or more, effects of improving compatibility of the alkali soluble resin (A) with other resin ingredients constituting the photosensitive resin composition can be enhanced. Meanwhile, when the content is adjusted to the upper limit or less, developing property or resolution of patterning of adhesion layer using photolithographic techniques can be improved. In addition, when the content of the alkali soluble resin (A) or the amount of liquid ingredients in the photosensitive resin composition is adjusted to be within this range, it is possible to attach a transparent substrate on a semiconductor device-provided substrate by thermocompression after the resin is patterned by photolithographic method.

The photosensitive resin composition of the present invention contains a photopolymerization initiator (B). For this reason, patterning property can be further improved.

Examples of the photopolymerization initiator (B) include, but are not particularly limited to, benzophenone, acetophenone, benzoin, benzoin isobutyl ether, methyl benzoin benzoate, benzoin benzoate, benzoin methyl ether, benzyl phenyl sulfide, benzyl, benzyl dimethyl ketal, dibenzyl, diacetyl and the like. Of these, benzophenone and benzyl dimethyl ketal are preferred from the viewpoint of superior patterning property.

The content of the photopolymerization initiator (B) is not particularly limited and is preferably 0.5 to 10% by weight, particularly preferably 1 to 5% by weight, based on the total weight of the photosensitive resin composition of the present invention. When the content of the photopolymerization initiator is adjusted within the lower limit or more, effects on photopolymerization initiation can be improved. Meanwhile, when the content is adjusted within the upper limit or less, suitable reactivity can be obtained and the preservability of photosensitive resin composition before use or resolution of photosensitive resin composition after patterning can be improved. Accordingly, by adjusting the content of the photopolymerization initiator (B) to be within this range, the photosensitive resin composition which exhibits superior balance between two properties can be provided.

The photosensitive resin composition of the present invention contains a compound (C) having a phenolic hydroxyl group and a carboxyl group. For this reason, affinity between the photosensitive resin composition and an alkali developing solution, and compatibility of the resin composition with other resin ingredients constituting the photosensitive resin composition can be improved. When the concentration of carboxyl groups in one molecule is increased, affinity to the alkali developing solution is improved. However, when the concentration is excessively high, crystallinity of molecules is improved, compatibility with other resin ingredients constituting the photosensitive resin composition may be deteriorated. For this reason, when, in addition to the carboxyl groups, phenolic hydroxyl groups having affinity to the alkali developing solution, although the affinity of hydroxyl group is lower than that of the carboxyl group, are incorporated in the photosensitive resin composition of the present invention, both affinity to the alkali developing solution and compatibility with other resin ingredients constituting the photosensitive resin composition can be improved. As a result, residues left after patterning by light-exposure and development can be reduced.

In addition, when a transparent substrate is adhered to a semiconductor device-provided substrate using a cured material of adhesive film made of the photosensitive resin as a spacer to fabricate a semiconductor device having a hollow structure, the photosensitive resin composition of the present invention contains the compound (C) having a phenolic hydroxyl group and a carboxyl group, thereby improving an effect on evaporating moisture present in hollow parts. As a result, the condensation of semiconductor devices can be reduced. The reason is considered that the compound having a phenolic hydroxyl group and a carboxyl group has a bulky structure, thus improving moisture permeability of the adhesive film and evaporating moisture present in hollow parts.

The weight-average molecular weight of the compound (C) having a phenolic hydroxyl group and a carboxyl group is not particularly limited and is preferably 100 or more, more preferably 150 or more, even more preferably 200 or more. As a result, affinity to the alkali developing solution and compatibility with other resin ingredients constituting the photosensitive resin composition can be improved. Meanwhile, the weight-average molecular weight of the compound (C) having a phenolic hydroxyl group and a carboxyl group is preferably 5,000 or less, more preferably 3,000 or less, even more preferably 2, 000 or less, even more preferably 500 or less, even more preferably 350 or less. As a result, both affinity to the alkali developing solution and compatibility with other resin ingredients constituting the photosensitive resin composition can be further improved. The weight-average molecular weight may be measured in the same as defined above.

The compound (C) having a phenolic hydroxyl group and a carboxyl group is not particularly limited so long as it has a phenolic hydroxyl group and a carboxyl group, and examples thereof include compounds represented by the following general formulae (1) to (3). By applying compounds represented by the following general formulae (1) to (3), effects on reducing both residues after patterning by light-exposure and development and condensation between the semiconductor wafer and the transparent substrate under a high temperature high humidity can be further improved.

[Chemical Formula 4]

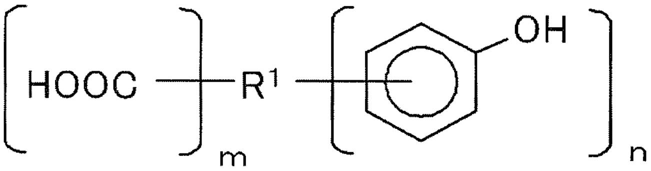 (1)

In formula (1), m and n are an integer of 1 to 3 and $R^1$ represents an organic group. In general formula (1), an aromatic ring may have other substituent groups, in addition to a hydroxyl group.

In general formula (1), m and n are not particularly limited and m=l and n=2 are preferred. When m and n have these values, effects on reducing residues after patterning the photosensitive resin composition by light-exposure and development and effects on improving compatibility with other resin ingredients constituting the photosensitive resin composition can be simultaneously improved.

In addition, when $R^1$ is an organic group, it is not particularly limited and represents a single bond or a straight or branched hydrocarbon group having 1 to 20 carbon atoms, more preferably, groups except for an aromatic group. In addition, when n is 1, specific examples of the organic group include methylene, ethylene, n-propylene, i-propylene, i-pentylene, sec-pentylene, t-pentylene, methylbutylene, 1,1-dimethylpropylene, n-hexylene, 1-methyl pentylene, 2-methylpentylene, 3-methylpentylene, 4-methylpentylene, 1-ethylbutylene, 2-ethylbutylene, 3-ethylbutylene, 1,1-dimethylbutylene, 2,2-dimethylbutylene, 3,3-dimethylbutylene, 1-ethyl-1-methylpropylene, n-heptylene, 1-methylhexylene, 2-methylhexylene, 3-methylhexylene, 4-methylhexylene, 5-methylhexylene, 1-ethylpentylene, 2-ethylpentylene, 3-ethylpentylene, 4-ethylpentylene, 1,1-dimethylpentylene, 2,2-dimethylpentylene, 3,3-dimethylpentylene, 4,4-dimethylpentylene, 1-propylbutylene, n-octylene, 1-methylheptylene, 2-methylheptylene, 3-methylheptylene, 4-methylheptylene, 5-methylheptylene, 6-methylheptylene, 1-ethylhexylene, 2-ethylhexylene, 3-ethylhexylene, 4-ethylhexylene, 5-ethylhexylene, 6-ethylhexylene, 1,1-dimethylhexylene, 2,2-dimethylhexylene, 3,3,-dimethylhexylene, 4,4-dimethylhexylene, 5,5-dimethylhexylene, 1-propylpentylene, 2-propylpentylene and the like and is preferably a straight or branched group having 1 to 6 carbon atoms. When the carbon number is within this range, effects on reducing residues after patterning the photosensitive resin composition by light-exposure and development and effects on improving compatibility with other resin ingredients constituting the photosensitive resin composition can be simultaneously improved.

In addition, the compound of general formula (1) wherein n is 2 is for example a group represented by the following general formula (4).

[Chemical Formula 5]

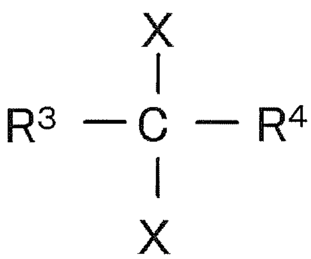 (4)

(In formula (4), $R^3$ and $R^4$ represent a hydrogen atom, a straight or branched alkyl group having 1 to 20 carbon atoms, a straight alkylene group having 1 to 20 carbon atoms (in which the end is a carboxyl group) or a carboxyl group, and a benzene ring having a phenolic hydroxyl group in the general formula (1) is bonded to X. However, both of $R^3$ and $R^4$ do not represent a hydrogen atom or a straight or branched alkyl group having 1 to 20 carbon atoms; when one of $R^3$ and $R^4$ represents a hydrogen atom or a straight or branched alkyl group having 1 to 20 carbon atoms, the other

represents a straight alkylene group having 1 to 20 carbon atoms (in which the end is a carboxyl group) or a carboxyl group)).

In general formula (4), at least one of $R^3$ and $R^4$ preferably represents a straight or branched alkylene group having 1 to 10 carbon atoms (in which the end is a carboxyl group), particularly preferably represents a straight or branched alkylene group having 1 to 6 carbon atoms (in which the end is a carboxyl group). When the carbon number is within this range, effects on reducing residues after patterning the photosensitive resin composition by light-exposure and development and effects on improving compatibility with other resin ingredients constituting the photosensitive resin composition can be improved.

In addition, the compound of general formula (1) wherein n is 3 is for example a group represented by the following general formula (5).

[Chemical Formula 6]

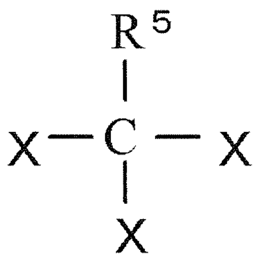

(5)

(In formula (5), $R^5$ represents a straight or branched alkylene group having 1 to 20 carbon atoms (in which the end is a carboxyl group), or a carboxyl group, and a benzene ring having a phenolic hydroxyl group in the general formula (1) is bonded to X).

In general formula (5), $R^5$ preferably represents a straight or branched alkylene group having 1 to 10 carbon atoms (in which the end is a carboxyl group), particularly preferably a straight or branched alkylene group having 1 to 6 carbon atoms (in which the end is a carboxyl group). When the carbon number is within this range, effects on reducing residues after patterning the photosensitive resin composition by light-exposure and development and effects on improving compatibility with other resin ingredients constituting the photosensitive resin composition can be improved.

In addition, in general formula (1), the aromatic ring may have other substituent groups, in addition to a hydroxyl group. The substituent group is not particularly limited and examples thereof include straight or branched alkyl groups having 1 to 10 carbon atoms, cycloalkyl groups, linear or branched alkylol groups having 1 to 10 carbon atoms, alkoxy silyl groups, aryl groups, phenyl groups, alkoxy groups, acyloxy groups, nitro groups, sulfone groups, cyano groups, halogen groups, ester groups, hydroxyl group, carboxyl groups and the like. In addition, in a case where the substituent group is present in plural, the substituent groups may be the same or different.

[Chemical Formula 7]

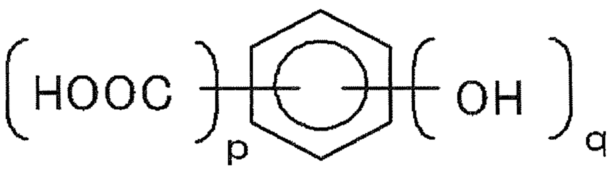

(2)

In formula (2), p and q are an integer of 1 to 5 under the condition that p+q=6. In general formula (2), the aromatic ring may have other substituent groups, in addition to a hydroxyl group or a carboxyl group.

The substituent group is particularly not limited and examples thereof include straight or branched alkyl groups having 1 to 10 carbon atoms, cycloalkyl groups, linear or branched alkylol groups having 1 to 10 carbon atoms, alkoxy

silyl groups, aryl groups, phenyl groups, alkoxy groups, acyloxy groups, nitro groups, sulfone groups, cyano groups, halogen groups, ester groups and the like. In addition, in a case where the substituent group is present in plural, the substituent groups may be the same or different.

Examples of compound that may be represented by the general formula (2) include, but are not particularly limited to, 2-hydroxybenzoic acid, 3-hydroxybenzoic acid, 4-hydroxybenzoic acid, 2,3-dihydroxybenzoic acid, 2,4-dihydroxybenzoic acid, 2,5-dihydroxybenzoic acid, 2,6-dihydroxybenzoic acid, 3,4-dihydroxybenzoic acid, 3,5-dihydroxybenzoic acid, 3,4,5-trihydroxybenzoic acid, 2,4,6-trihydroxybenzoic acid, 4-hydroxyisophthalic acid, 5-hydroxyisophthalic acid and the like. Of these, 2,3-dihydroxybenzoic acid, 2,4-dihydroxybenzoic acid, 2,5-dihydroxybenzoic acid, 2,6-dihydroxybenzoic acid, 3,4-dihydroxybenzoic acid, 3,4,5-trihydroxybenzoic acid and 2,4,6-trihydroxybenzoic acid are preferred from the viewpoint that effects on reducing residues after patterning the photosensitive resin composition by light-exposure and development, and effects on improving compatibility with other resin ingredients constituting the photosensitive resin composition can be improved.

[Chemical Formula 8]

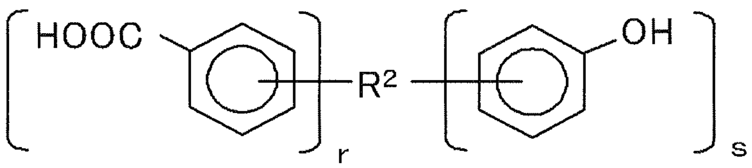

(3)

In formula (3), r and s are an integer of 1 to 3, and $R^2$ represents an organic group, a single bond, -O-, -S-, or $-SO_2-$. In general formula (3), the aromatic ring may have other substituent groups, in addition to a hydroxyl group or a carboxyl group.

In general formula (3), r and s are not particularly limited and r=1 and s=2 are preferred. When r and s have these values, effects on reducing residues after patterning the photosensitive resin composition by light-exposure and development and effects on improving compatibility with other resin ingredients constituting the photosensitive resin composition can be improved.

In addition, in general formula (3), $R^2$ is not particularly limited so long as it represents an organic group, a single bond, -O-, -S-, or $-SO_2-$, and examples thereof include -CO-, -NHCO-, a hydrogen atom, straight or branched hydrocarbon groups having 1 to 20 carbon atoms, more preferably, groups except for aromatic groups. In addition, $R^2$ is more preferably a straight or branched hydrocarbon group having 1 to 10 carbon atoms, particularly preferably a straight or branched hydrocarbon group having 1 to 6 carbon atoms. When the carbon number is within this range, effects on reducing residues after patterning the photosensitive resin composition by light-exposure and development and effects on improving compatibility with other resin ingredients constituting the photosensitive resin composition can be improved.

In addition, in general formula (3), the aromatic ring may have other substituent groups, in addition to a hydroxyl group or a carboxyl group. The substituent group is not particularly limited and examples thereof include straight or branched alkyl groups having 1 to 10 carbon atoms, cycloalkyl groups, linear or branched alkylol groups having 1 to 10 carbon atoms, alkoxy silyl groups, aryl groups, phenyl groups, alkoxy groups, acyloxy groups, nitro groups, sulfone groups, cyano groups, halogen groups, ester groups, hydroxyl groups, carboxyl groups and the like. In addition, in a case where the substitution group is present in plural, the substitution groups may be the same or different.

Examples of the compound that may be represented by the general formula (3) include, but are not particularly limited to, phenolphthalein, phenolphthalein derivatives and the like. Of these, phenolphthalein is preferred. As a result, effects on reducing residues after patterning the photosensitive resin composition by light-exposure and development, and effects on improving compatibility with other resin ingredients constituting the photosensitive resin composition can be improved.

The content of the compound (C) having a phenolic hydroxyl group and a carboxyl group is not particularly limited and is preferably 0.1% by weight or more, more preferably 0.3% by weight or more, even more preferably, 0.5% by weight from the viewpoints of reduction of residues of photosensitive resin composition after patterning by light-exposure and development and dimensional stability of patterns (inhibition of decrease in films of light-exposed regions). Meanwhile, the content of the compound (C) having a phenolic hydroxyl group and a carboxyl group is preferably 30% by weight or less, more preferably 20% by weight or less, particularly preferably 15% by weight. As a result, it is possible

to reduce residues left after patterning, secure compatibility with other resin ingredients constituting the photosensitive resin composition and suitably use the resin composition for the spacer.

The photosensitive resin composition of the present invention may further contain a thermosetting resin (D). It is possible to improve an adhesion property between a semiconductor device-provided substrate and a transparent substrate, when the two substrates are adhered to each other using a cured material of adhesive film made of the photosensitive resin composition as a spacer, by incorporating the thermosetting resin (D) in the photosensitive resin composition.

Examples of the thermosetting resin (D) include, but are not particularly limited to novolac-type phenol resins such as phenol novolac resins, cresol novolac resins, bisphenol A novolac resins and the like, phenol resins such as resol phenol resins and the like, bisphenol-type epoxy resins such as bisphenol A epoxy resins and bisphenol F epoxy resins and the like, novolac-type epoxy resins such as novolac epoxy resins, cresol novolac epoxy resins and the like, epoxy resins such as biphenyl-type epoxy resins, stilbene-type epoxy resins, triazine core-containing epoxy resins, dicyclopentadiene-type epoxy resins, trisphenolmethane-type epoxy resins, naphthalene-type epoxy resins, silicone-modified epoxy resins and the like, triazine ring-containing resins such as urea resins, melamine resins and the like, unsaturated polyester resins, bismaleimide resins, polyurethane resins, diarylphthalate resins, silicone resins, benzoxazine ring-containing resins, cyanate ester resins and the like. Of these, epoxy resins are preferred from the viewpoints that they can increase free volume of the cured material of adhesive film made of the photosensitive resin composition and moisture permeability of the cured material can be improved. More specifically, phenol novolac-type epoxy resins, cresol novolac-type epoxy resins, dicyclopentadiene-type epoxy resins, and trisphenolmethane-type epoxy resins are preferred from the viewpoints that they can decrease moisture absorption of the cured material of adhesive film and improve moisture permeability.

The content of the thermosetting resin (D) is not particularly limited and is preferably 10 to 70% by weight, more preferably 15 to 65% by weight, particularly preferably 20 to 60% by weight. When the content is within this range, an adhesion property can be further improved and mechanical properties of the cured material of adhesive film made of the photosensitive resin composition can be further improved.

In addition, when an epoxy resin is used as the thermosetting resin (D), a compound serving as a curing agent of the epoxy resin may be further added to the photosensitive resin composition. Examples of compound serving as the curing agent of the epoxy resin include, but are not particularly limited to, phenol derivatives, carbonic acid derivatives, imidazoles and the like. Of these, phenol derivatives are preferred from the viewpoints that they can serve as dissolution promoters during patterning using light-exposure and development and exhibit superior mechanical properties of the cured material of adhesive film made of the photosensitive resin composition.

Examples of the phenol derivatives include phenol novolac resins, phenylene skeleton-containing phenol aralkyl resins, trisphenolmethane-type phenol resins, biphenyl aralkyl-type phenol resins, α-naphthol aralkyl-type phenol resins, β-naphthol aralkyl-type phenol resins and the like. Of these, phenol novolac resins are preferred. The use of phenol novolac resins enables further reduction of residues after patterning by light-exposure and development.

In addition, the photosensitive resin composition of the present invention may contain a photopolymerizable compound (E) which is different from the alkali soluble resin (A). As a result, the photosensitivity of the photosensitive resin composition can be improved.

The photopolymerizable compound (E) may be a first photopolymerizable compound having a hydrophilic group. As a result, residues after patterning by light-exposure and development can be reduced. The reason is considered that the hydrophilic group is imparted to improve affinity with water, thus causing the photosensitive resin composition to be readily dissolved in the alkali developing solution.

Examples of the first photopolymerizable compound having a hydrophilic group include hydroxyl group-containing acryl-based compounds, ethylene glycol-containing acryl-based compounds and the like. Of these, the hydroxyl group-containing acryl-based compounds are preferred. As a result, the patterning property (developing property) can be improved.

As the hydroxyl group-containing acryl-based compounds, (meth)acrylic acid-based adducts of epoxy compounds are preferred. More specifically, examples of (meth)acrylic acid-based adducts include adducts of ethylene glycol diglycidyl ether and methacrylic acid, adducts of propylene glycol diglycidyl ether and acrylic acid, adducts of tripropylene glycol diglycidyl ether and acrylic acid, adducts of bisphenol A diglycidyl ether and methacrylic acid and the like.

The epoxy compounds are preferably aromatic ring-containing epoxy compounds. As a result, a shape retaining property is excellent. Of these, at least one compound selected from the following formula (6) is preferred. As a result, a shape retaining property of semiconductor devices as spacers as well as reduction effects of residues is excellent.

[Chemical Formula 9]

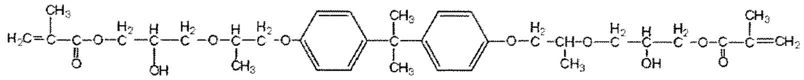

(6-1)

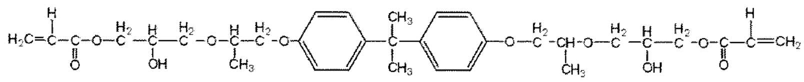

(6-2)

(6)

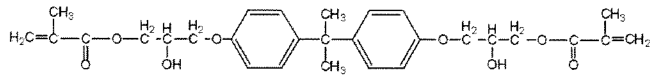

(6-3)

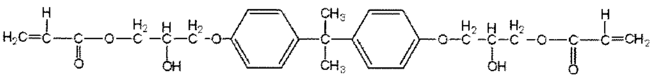

(6-4)

The content of the first photopolymerizable compound having a hydrophilic group is not particularly limited, but is preferably 1 to 20% by weight, particularly preferably 2 to 8% by weight, based on the total weight of the photosensitive resin composition of the present invention. When the content is within this range, balanced effects between reduction of residues and a shape retaining property of semiconductor devices as spacers can be improved.

In addition, the photopolymerizable compound (E) may be a second photopolymerizable compound different from the first photopolymerizable compound. As a result, a patterning property together with the alkali soluble resin (A) can be further improved. In addition, the second photopolymerizable compound is different from the first photopolymerizable compound in terms of structure, molecular weight and the like.

Examples of the second photopolymerizable compound include glycerin dimethacrylate, trimethylolpropane triacrylate, trimethylolpropane trimethacrylate, pentaerythritol triacrylate, pentaerythritol tetraacrylate, dipentaerythritol hexaacrylate and the like.

Of the second photopolymerizable compounds, 2- or more functional second photopolymerizable compounds are preferred, and 3- or more functional second photopolymerizable compounds are particularly preferred. As a result, although a filler is not substantially contained, a shape retaining property of the spacer of the semiconductor device is excellent.

Examples of the 3- or more functional second photopolymerizable compound include trimethylol propane trimethacrylate, pentaerythritol triacrylate and the like. The reason for obtaining an excellent shape retaining property for the spacer of the semiconductor device, when the 3- or more functional second photopolymerizable compound is used, although a filler is not substantially contained, is that three-dimensional photocrosslinking occurs, the photocrosslinking density increases and the elastic modulus during heating does not decrease.

The content of the second photopolymerizable compound is not particularly limited and is preferably 5 to 50% by weight, particularly preferably 10 to 40% by weight, based on the total weight of the photosensitive resin composition of the present invention. When the content is higher than the upper limit, adhesion strength may be deteriorated, and when the content is lower than the lower limit, a shape retaining property may be deteriorated.

In particular, when a combination of the first photopolymerizable compound having a hydrophilic group and the second photopolymerizable compound (particularly preferably, 3- or more functional second photopolymerizable compound) is used as the photopolymerizable compound (E), a photosensitive resin composition which has superior effects on reduction of residues when the spacers of the semiconductor device are formed and on a shape retaining property of the spacers can be obtained.

A combination ratio of the first photopolymerizable compound and the second photopolymerizable compound is not particularly limited, but is preferably 0.05 to 1.5 (content of the first photopolymerizable compound/content of second photopolymerizable compound), particularly preferably 0.1 to 1.0. When the combination ratio is within this range, in addition to effects on residue reduction and a shape retaining property, workability, micro-processability and reliability are excellent.

The photosensitive resin composition of the present invention may further contain additives such as ultraviolet absorbers and leveling agents so long as the object of the present invention is not impaired.

In addition, in particular, in a case where reduction of residues after patterning is required, the photosensitive

resin composition of the present invention preferably does not contain an inorganic filler, or contains 5% by weight or less of an inorganic filler based on the total weight of the photosensitive resin composition.

Meanwhile, in particular, in a case where properties such as heat resistance, dimensional stability and moisture resistance are required, the photosensitive resin composition of the present invention may further contain an inorganic filler. In addition, in the following case of using as an adhesive film, a detachment property of the adhesive film to a protective film can be improved.

Examples of the inorganic filler include silicates such as talc, sintered clay, non-sintered clay, mica, glass and the like, oxides such as titanium oxide, alumina, silica powder such as fused silica (fused spherical silica or fused ground silica) and crystalline silica and the like, carbonates such as calcium carbonate, magnesium carbonate, hydrotalcite and the like, hydroxides such as aluminum hydroxide, magnesium hydroxide and calcium hydroxide, sulfates or sulfites such as barium sulfate, calcium sulfate, calcium sulfite and the like, borates such as zinc borate, bariummetaborate, aluminum borate, calcium borate, sodium borate and the like, and nitrides such as aluminum nitride, boron nitride, silicon nitride and the like. These inorganic fillers may be used singly or in combination thereof. Of these, a silica powder such as fused silica or crystalline silica is preferred and spherical fused silica is particularly preferred.

By incorporating the inorganic filler in the photosensitive resin composition of the present invention, heat resistance, moisture resistance, strength and the like after the photosensitive resin composition is cured can be improved. In addition, in the case of use as an adhesive film, a detachment property of the adhesive film to a protective film can be improved. In addition, the shape of inorganic filler is not particularly limited and a fine spherical shape is preferred. As a result, the photosensitive resin composition which is suitable for an adhesive film which has no anisotropy can be obtained.

In addition, the mean particle size of the inorganic filler is not particularly limited, but is preferably 5 to 50 nm, particularly preferably 10 to 30 nm. When the mean particle size is lower than the lower limit, the inorganic filler is readily aggregated, thus causing deterioration in strength, and when the mean particle size is higher than the upper limit, a resolution of patterning of the adhesive layer by light-exposure and photolithographic techniques may be often deteriorated.

(Adhesive film)

The photosensitive resin composition of the present invention may be used as an adhesive film. For example, the photosensitive resin composition of the present invention may be mixed with a suitable organic solvent (for example, N-methyl-2-pyrrolidone, anisole, methyl ethyl ketone, toluene, ethyl acetate and the like), followed by applying and drying on a support film or the like, to obtain an adhesive film.

(Light-receiving device)

FIG. 1 is a sectional view illustrating a light-receiving device according to one embodiment of the present invention.

As shown in FIG. 1, the light-receiving device 100 includes: a semiconductor device-mounted substrate 1 on which a semiconductor device 11 is mounted; a transparent substrate 2 which is located so as to face the semiconductor device-mounted substrate 1; and a spacer 4 interposed between the semiconductor device-mounted substrate 1 and the transparent substrate 2. The spacer 4 enables formation of a space 3 between the semiconductor device-mounted substrate 1 and the transparent substrate 2. The semiconductor device 11 has a light-receiving unit 111, and the semiconductor device 11 and the semiconductor device-mounted substrate 1 are electrically bonded to each other by a bonding wire 13. The spacer 4 is a cured material made of the photosensitive resin composition of the present invention.

When the photosensitive resin composition of the present invention is for example used as the spacer 4, a method of applying a paste-type photosensitive resin composition, a method of laminating a film-type photosensitive resin composition or the like may be used. Of these, the method of laminating the film-type photosensitive resin composition is preferred. The method provides excellent micro-processability. In addition, the method enables the thickness of the spacer 4 to be easily maintained at a predetermined level.

In a case where the spacer 4 of the light-receiving device 100 is formed using the photosensitive resin composition of the present invention, as shown in FIG. 1, the spacer 4 exhibits superior dimensional stability (stability of Z-direction height), thus affording the light-receiving device 100 with a superior imaging property (prevention of image distortion). In addition, the spacer 4 exhibits a superior air-tightness property (foreign materials such as dust and waste are not incorporated in hollow parts), thus affording the light-receiving device 100 with a superior imaging property (prevention of defects (black spots) of images). The photosensitive resin composition of the present invention has a thermal adhesive property after photocuring and can satisfy one of the properties required for the spacer 4.

The light-receiving device 100 mentioned above is suitable for use in CCD image sensors, CMOS image sensors, pressure sensors, piezoelectric sensors and acceleration sensors.

[Examples]

Hereinafter, the present invention will be described in detail, based on the following Examples and Comparative Examples and is not limited thereto.

(Example 1)

1. Synthesis of resin having an alkali soluble group and a double bond (a curable resin that may be cured by light and heat: methacyl-modified bisphenol A-type phenol novolac resin: MPN001);

500 g of a MEK solution (solid 60%) of a bisphenol A-type novolac resin (PHENOLITE LF-4871, manufactured by Dainippon Ink & Chemicals, Inc.) was added to a 2L flask, 1.5 g of tributylamine as a catalyst and 0.15 g of hydroquinone as a polymerization inhibitor were added thereto, followed by heating to 100°C. At this time, 180.9 g of glycidyl methacrylate was added dropwise for 30 minutes, followed by reacting while stirring at 100°C for 5 hours, to obtain a methacryl-modified bisphenol A-type phenol novolac resin (nonvolatile matter of 74% and methacryl-modification ratio of 50%).

2. Preparation of resin varnish;

40.0% by weight of the methacryl-modified bisphenol A-type phenol novolac resin (MPN) as an alkali-soluble resin, 3.0% by weight of IRGACURE 651 (manufactured by Ciba Specialty Chemicals Co., Ltd.) as a photopolymerization initiator, 2.0% by weight of 4,4-bis(4-hydroxyphenyl)valeric acid (weight-average molecular weight of 286, manufactured by Tokyo Kasei Kogyo Co., Ltd.) as a compound having a phenolic hydroxyl group and a carboxyl group, 30.0% by weight of EP-1001 (manufactured by Japan Epoxy Resins Co., Ltd.) as an epoxy resin, 5.0% by weight of a silicone epoxy resin (BY16-115, manufactured by Toray-Dow Corning Silicone Co., Ltd.,) as an epoxy resin, 5.0% by weight of an adduct of diglycidyl ether of a bisphenol A propylene oxide 2 mole adduct and methacrylic acid (EPOXY ESTER 3002 M manufactured by KYOEISHA CHEMICAL Co., LTD,) as a first photopolymerizable compound having a hydrophilic group, and 15.0% by weight of trimethylol propane trimethacrylate (light ester TMP manufactured by KYOEISHA CHEMICAL Co., LTD.), a 3-functional photopolymerizable compound, as a second photopolymerizable compound, were dissolved in methyl ethyl ketone (MEK, manufactured by Daeshin Chemical Co., Ltd.) to obtain a resin varnish.

3. Preparation of adhesive film;

The resin varnish was applied to a support material polyester film (RL-07, manufactured by Teij in Dupont Film Co., Ltd., thickness of 38 μm) using a comma coater and dried at 70°C for 10 minutes to obtain an adhesive film with a thickness of 50 μm.

4. Fabrication of light-receiving device;

The adhesive film was adhered to on a 6-inch wafer using a base substrate provided with a micro lens array and a laminator set at 60°C. Then, the adhesive film was exposed to light using a negative-type mask and a light-exposure system, followed by developing to manufacture patterning samples. The patterning shape and arrangements were designed to surround respective light-receiving units of the imaging device with a frame having a width (100 μm). In addition, the exposure was carried out by irradiating light of 700 mJ/$cm^2$ with a wavelength of 365 nm and the development was carried out using 3% TMAH (tetraammonium hydroxide) at a spray pressure of 0.2 MPa for 60 seconds. The patterning sample thus obtained was fragmented and a glass substrate (5 mm×4mm×0.5mm) was adhered thereto by thermocompression (at a temperature of 80°C, over a period of 5 seconds, at a pressure of 0.2 MPa). The sample was cured at 180 °C for 2 hours, placed on a substrate for evaluation and brought in contact with the substrate to obtain samples for evaluation (light-receiving devices).

(Example 2)

Preparation of a resin varnish, preparation of an adhesive film and fabrication of a light-receiving device were performed in the same manner as in Example 1, except that the mixed amount of 4,4-bis(4-hydroxyphenyl)valeric acid (manufactured by Tokyo Kasei Kogyo Co., Ltd.) was changed from 2.0% by weight to 7.0% by weight and the mixed amount of EP-1001 (manufactured by Japan Epoxy Resins Co., Ltd.) was changed from 30.0% by weight to 25.0% by weight.

(Example 3)

Preparation of a resin varnish, preparation of an adhesive film and fabrication of a light-receiving device were performed in the same manner as in Example 1, except that 2.0% by weight of 2,4,6-trihydroxybenzoic acid (manufactured by Tokyo Kasei Kogyo Co., Ltd., weight average molecular weight of 170) was used, instead of 2.0% by weight of 4,4-bis(4-hydroxyphenyl)valeric acid (manufactured by Tokyo Kasei Kogyo Co., Ltd.).

(Example 4)

Preparation of a resin varnish, preparation of an adhesive film and fabrication of a light-receiving device were performed in the same manner as in Example 3, except that the mixed amount of 2,4,6-trihydroxybenzoic acid (manufactured by Tokyo Kasei Kogyo Co., Ltd.) was changed from 2.0% by weight to 7.0% by weight, and the mixed amount of EP-1001 (manufactured by Japan Epoxy Resins Co., Ltd.) was changed from 30.0% by weight to 25.0% by weight.

(Example 5)

Preparation of a resin varnish, preparation of an adhesive film and fabrication of a light-receiving device were performed in the same manner as in Example 1, except that 2.0% by weight of phenolphthalein (manufactured by Tokyo Kasei Kogyo Co., Ltd., weight average molecular weight of 320) was used, instead of 2.0% by weight of 4,4-bis (4-hydroxyphenyl) valeric acid (manufactured by Tokyo Kasei Kogyo Co., Ltd.).

(Example 6)

Preparation of a resin varnish, preparation of an adhesive film and fabrication of a light-receiving device were performed in the same manner as in Example 1, except that 30.0% by weight of EP-1032H (manufactured by Japan Epoxy Resins Co., Ltd.) was used, instead of 30.0% by weight of EP-1001 (manufactured by Japan Epoxy Resins Co., Ltd.).

(Example 7)

Preparation of a resin varnish, preparation of an adhesive film and fabrication of a light-receiving device were performed in the same manner as in Example 1, except that 30.0% by weight of YDCN800-70 (manufactured by Toto Kasei Co., Ltd.) was used, instead of 30.0% by weight of EP-1001 (manufactured by Japan Epoxy Resins Co., Ltd.).

(Example 8)

Preparation of a resin varnish, preparation of an adhesive film and fabrication of a light-receiving device were performed in the same manner as in Example 1, except that the mixed amount of methacryl-modified bisphenol A-type phenol novolac resin (MPN001) was changed from 40.0% by weight to 35.0% by weight, 30.0% by weight of EP-1032H (manufactured by Japan Epoxy Resins Co., Ltd.) was used, instead of 30.0% by weight of EP-1001 (manufactured by Japan Epoxy Resins Co., Ltd.), and 5.0% by weight of PR53467 (manufactured by Sumitomo Bakelite Co., Ltd.) was added as a phenol novolac resin.

(Example 9)

Preparation of a resin varnish, preparation of an adhesive film and fabrication of a light-receiving device were performed in the same manner as in Example 6, except that 2.0% by weight of 4-hydroxybenzoic acid (manufactured by Tokyo Kasei Kogyo Co., Ltd., weight-average molecular weight of 138) was used, instead of 2.0% by weight of 4,4-bis(4-hydroxyphenyl)valeric acid (manufactured by Tokyo Kasei Kogyo Co., Ltd.).

(Example 10)

Preparation of a resin varnish, preparation of an adhesive film and fabrication of a light-receiving device were performed in the same manner as in Example 6, except that 2.0% by weight of 3,4-dihydroxy benzoic acid (manufactured by Tokyo Kasei Kogyo Co., Ltd., weight average molecular weight of 154) was used, instead of 2.0% by weight of 4,4-bis(4-hydroxyphenyl)valeric acid (manufactured by Tokyo Kasei Kogyo Co., Ltd.).

(Example 11)

Preparation of a resin varnish, preparation of an adhesive film and fabrication of a light-receiving device were performed in the same manner as in Example 6, except that 2.0% by weight of 3-hydroxy-p-toluic acid (manufactured by Tokyo Kasei Kogyo Co., Ltd., weight average molecular weight of 152) was used, instead of 2.0% by weight of 4,4-bis(4-hydroxyphenyl)valeric acid (manufactured by Tokyo Kasei Kogyo Co., Ltd.).

(Example 12)

Preparation of a resin varnish, preparation of an adhesive film and fabrication of a light-receiving device were performed in the same manner as in Example 6, except that 2.0% by weight of 3,4-dihydroxymandelic acid (manufactured by Tokyo Kasei Kogyo Co., Ltd., weight-average molecular weight of 184) was used, instead of 2.0% by weight of 4,4-bis(4-hydroxyphenyl)valeric acid (manufactured by Tokyo Kasei Kogyo Co., Ltd.).

(Example 13)

Preparation of a resin varnish, preparation of an adhesive film and fabrication of a light-receiving device were performed in the same manner as in Example 6, except that 2.0% by weight of 3-phenylsalicylic acid (manufactured by Tokyo Kasei Kogyo Co., Ltd., weight-average molecular weight of 214) was used, instead of 2.0% by weight of 4,4-bis (4-hydroxyphenyl)valeric acid (manufactured by Tokyo Kasei Kogyo Co., Ltd.).

(Example 14)

Preparation of a resin varnish, preparation of an adhesive film and fabrication of a light-receiving device were performed in the same manner as in Example 6, except that 2.0% by weight of 4-hydroxyphenylacetic acid (manufactured by Tokyo Kasei Kogyo Co., Ltd., weight-average molecular weight of 152) was used, instead of 2.0% by weight of 4,4-bis(4-hydroxyphenyl)valeric acid (manufactured by Tokyo Kasei Kogyo Co., Ltd.).

(Example 15)

Preparation of a resin varnish, preparation of an adhesive film and fabrication of a light-receiving device were performed in the same manner as in Example 6, except that 2.0% by weight of 3,4-dihydroxyphenylacetic acid (manufactured by Tokyo Kasei Kogyo Co., Ltd., weight-average molecular weight of 168) was used, instead of 2.0% by weight of 4,4-bis(4-hydroxyphenyl)valeric acid (manufactured by Tokyo Kasei Kogyo Co., Ltd.).

(Example 16)

Preparation of a resin varnish, preparation of an adhesive film and fabrication of a light-receiving device were performed in the same manner as in Example 6, except that 2.0% by weight of 2-(4-hydroxyphenyl) propionic acid (manufactured by Tokyo Kasei Kogyo Co., Ltd., weight-average molecular weight of 166) was used, instead of 2.0% by weight of 4,4-bis(4-hydroxyphenyl)valeric acid (manufactured by Tokyo Kasei Kogyo Co., Ltd.).

(Example 17)

Preparation of a resin varnish, preparation of an adhesive film and fabrication of a light-receiving device were performed in the same manner as in Example 6, except that 2.0% by weight of 3-(4-hydroxyphenyl)propionic acid (manufactured by Tokyo Kasei Kogyo Co., Ltd., weight-average molecular weight of 166) was used, instead of 2.0% by weight of 4,4-bis(4-hydroxyphenyl)valeric acid (manufactured by Tokyo Kasei Kogyo Co., Ltd.).

(Example 18)

Preparation of a resin varnish, preparation of an adhesive film and fabrication of a light-receiving device were performed in the same manner as in Example 6, except that 2.0% by weight of 4-(4-hydroxyphenyl)benzoic acid (manufactured by Tokyo Kasei Kogyo Co., Ltd., weight-average molecular weight of 214) was used, instead of 2.0% by weight of 4,4-bis(4-hydroxyphenyl)valeric acid (manufactured by Tokyo Kasei Kogyo Co., Ltd.).

(Example 19)

Preparation of a resin varnish, preparation of an adhesive film and fabrication of a light-receiving device were performed in the same manner as in Example 6, except that 2.0% by weight of 4-(4-hydroxyphenoxy)benzoic acid (manufactured by Tokyo Kasei Kogyo Co., Ltd., weight-average molecular weight of 230) was used, instead of 2.0% by weight of 4,4-bis(4-hydroxyphenyl)valeric acid (manufactured by Tokyo Kasei Kogyo Co., Ltd.).

(Example 20)

Preparation of a resin varnish, preparation of an adhesive film and fabrication of a light-receiving device were performed in the same manner as in Example 6, except that 2.0% by weight of methylene disalicylic acid (manufactured by Tokyo Kasei Kogyo Co., Ltd., weight-average molecular weight of 288) was used, instead of 2.0% by weight of 4,4-bis(4-hydroxyphenyl)valeric acid (manufactured by Tokyo Kasei Kogyo Co., Ltd.).

(Example 21)

Preparation of a resin varnish, preparation of an adhesive film and fabrication of a light-receiving device were performed in the same manner as in Example 6, except that 2.0% by weight of 4-(2-hydroxyethoxy) salicylic acid (manufactured by Tokyo Kasei Kogyo Co., Ltd., weight-average molecular weight of 198) was used, instead of 2.0% by weight of 4,4-bis(4-hydroxyphenyl)valeric acid (manufactured by Tokyo Kasei Kogyo Co., Ltd.).

(Example 22)

Preparation of a resin varnish, preparation of an adhesive film and fabrication of a light-receiving device were performed in the same manner as in Example 6, except that 2.0% by weight of 2,6-dihydroxy-4-methylbenzoic acid (manufactured by Tokyo Kasei Kogyo Co., Ltd., weight-average molecular weight of 168) was used, instead of 2.0% by weight of 4,4-bis(4-hydroxyphenyl)valeric acid (manufactured by Tokyo Kasei Kogyo Co., Ltd.).

(Example 23)

Preparation of a resin varnish, preparation of an adhesive film and fabrication of a light-receiving device were performed in the same manner as in Example 6, except that 2.0% by weight of 5-hydroxyisophthalic acid (manufactured by Tokyo Kasei Kogyo Co., Ltd., weight-average molecular weight of 182) was used, instead of 2.0% by weight of 4,4-bis(4-hydroxyphenyl)valeric acid (manufactured by Tokyo Kasei Kogyo Co., Ltd.).

(Example 24)

Preparation of a resin varnish, preparation of an adhesive film and fabrication of a light-receiving device were performed in the same manner as in Example 6, except that 2.0% by weight of 5,5'-thiodisalicylic acid (manufactured by Tokyo Kasei Kogyo Co., Ltd., weight-average molecular weight of 306) was used, instead of 2.0% by weight of 4,4-bis(4-hydroxyphenyl)valeric acid (manufactured by Tokyo Kasei Kogyo Co., Ltd.).

(Example 25)

Preparation of a resin varnish, preparation of an adhesive film and fabrication of a light-receiving device were performed in the same manner as in Example 6, except that 2.0% by weight of 2-hydroxy-5-sulfobenzoic acid (manufactured by Tokyo Kasei Kogyo Co., Ltd., weight-average molecular weight of 218) was used, instead of 2.0% by weight of 4,4-bis (4-hydroxyphenyl) valeric acid (manufactured by Tokyo Kasei Kogyo Co., Ltd.).

(Example 26)

Preparation of a resin varnish, preparation of an adhesive film and fabrication of a light-receiving device were performed in the same manner as in Example 6, except that 2.0% by weight of 6-hydroxy-1-naphthoic acid (manufactured by Tokyo Kasei Kogyo Co., Ltd., weight-average molecular weight of 188) was used, instead of 2.0% by weight of 4,4-bis(4-hydroxyphenyl)valeric acid (manufactured by Tokyo Kasei Kogyo Co., Ltd.).

(Comparative Example 1)

Preparation of a resin varnish, preparation of an adhesive film and fabrication of a light-receiving device were performed in the same manner as in Example 1, except that the mixed amount of EP-1001 (manufactured by Japan Epoxy Resins Co., Ltd.) was changed from 30.0% by weight to 32.0% by weight and the mixed amount of 4,4-bis(4-hydroxyphenyl)valeric acid (manufactured by Tokyo Kasei Kogyo Co., Ltd.) was changed from 2.0% by weight to 0% by weight.

Respective adhesive films and light-receiving devices obtained in Examples and Comparative Examples were evaluated as follows. The evaluation items and a detailed description thereof are described below. The results thus obtained are shown in Tables 1 to 3.

1. Evaluation of moisture permeability

The adhesive films in Examples and Comparative Examples were adhered using a laminator set at 60°C to manufacture films with a thickness of 100 μm, irradiated at an exposure amount of 750 mJ/$cm^2$ (wavelength of 365 nm) using an exposure system and thermally cured at 120°C/one hour and 180°C/one hour. The cured adhesive films were evaluated under 40°C/90% RH conditions based on the humidity cup method (JIS Z0208) to calculate moisture permeability.

2. Evaluation of moisture absorption ratio

The adhesive films in Examples and Comparative Examples were adhered using a laminator set at 60°C to manufacture films with a thickness of 100 μm and thermally cured at 180°C/two hours. The cured adhesive films were crushed in a box of about 5 mm square and about 10 mg thereof was weighed. Then, the weighed samples were thermally treated at 85°C for 10 minutes and the samples were weighted (at this time, the weight is represented by "a"). Then, the samples were thermally treated at 85°C under 85% RH for 10 minutes and weighed after 10 minutes (at this time, the weight is represented by "b"). The moisture absorption ratio was calculated by the following formula.

$$\text{Moisture absorption ratio (\%)} = \{(b-a)/a\}\times 100$$

3. Evaluation of residues after development

Developing property evaluation was carried out by laminating an adhesive film on a semiconductor wafer (at a temperature of 60°C and at a rate of 0. 3m/min), exposed at an amount of (700 mJ/$cm^2$) such that resin spacers were left in the form of a lattice using pattern masks and developed using 2.3% TMAH (at a development pressure of 0.2 MPa for a development period of 150 seconds). The obtained lattice patterns were observed by an optical microscope (X 1,000) and presence of residues were evaluated. The respective symbols have the following meaning:

AA: No residue and no practical problem.
BB: Slight residues and no practical problem.
CC: Slight residues and practically inapplicable.
DD: Much residues and practically inapplicable.

In addition, the pattern mask was in the form of a lattice having a resin width of 1.2 mm and a gap of 5 mm.

4. Evaluation of condensation of light-receiving device

The light-receiving devices were treated in a high temperature high humidity chamber at 85°C and at 85% for 500 hours and 1000 hours. After the treatment for the predetermined period, the light-receiving devices were isolated from the high temperature high humidity chamber and whether condensation (such as water drops and fog) on glass surfaces in hollow parts of light-receiving devices had occurred was immediately observed by a microscope (X50).

AA: No condensation even after a treatment period of 1000 hours
BB: No condensation after a treatment period of 500 hours, but condensation after a treatment period of 1000 hours
DD: Condensation after a treatment period of 500 hours

5. Evaluation of reliability of light-receiving devices

The obtained light-receiving devices were subjected to a temperature cycle test in which treatment at -55°C for one hour and at 125°C for one hour was repeated over 1000 cycles (n=10), and cracks and detachment were observed by an electric microscope (X5,000). The respective symbols have the following meaning.

AA: all samples exhibit neither cracks nor detachment and have no practical problem.
DD: 3 or more samples exhibit neither cracks nor detachment, which are not practically applicable.

[TABLE 1]

| | Ex. 1 | Ex. 2 | Ex.3 | Ex. 4 | Ex. 5 | Ex. 6 | Ex.7 | Ex. 8 | Ex. 9 |
|---|---|---|---|---|---|---|---|---|---|
| MPN001 | 40.0 | 40.0 | 40.0 | 40.0 | 40.0 | 40.0 | 40.0 | 35.0 | 40.0 |
| IRGACURE 651 | 3.0 | 3.0 | 3.0 | 3.0 | 3.0 | 3.0 | 3.0 | 3.0 | 3.0 |
| 4,4-bis(4-hydroxyphenyl)valeric acid | 2.0 | 7.0 | | | | 2.0 | 2.0 | 2.0 | |
| 2,4,6-trihydroxybenzoic acid | | | 2.0 | 7.0 | | | | | |
| Phenolphthalein | | | | | 2.0 | | | | |
| 4-hydroxybenzoic acid | | | | | | | | | 2.0 |
| EP-1001 | 30.0 | 25.0 | 30.0 | 25.0 | 30.0 | | | | |
| EP-1032H | | | | | | 30.0 | | 30.0 | 30.0 |
| YDCN800-70 | | | | | | | 30.0 | | |
| BY16-115 | 5.0 | 5.0 | 5.0 | 5.0 | 5.0 | 5.0 | 5.0 | 5.0 | 5.0 |
| PR53467 | | | | | | | | 5.0 | |
| Epoxy ester 3002 M 5.0 | | 5.0 | 5.0 | 5.0 | 5.0 | 5.0 | 5.0 | 5.0 | 5.0 |
| Light ester TMP | 15.0 | 15.0 | 15.0 | 15.0 | 15.0 | 15.0 | 15.0 | 15.0 | 15.0 |
| Total | 100.0 | 100.0 | 100.0 | 100.0 | 100.0 | 100.0 | 100.0 | 100.0 | 100.0 |
| Moisture permeability ($g/m^2/24h$) | 18 | 17 | 17 | 16 | 18 | 21 | 30 | 23 | 21 |
| Moisture absorption ratio (%) | 1.9 | 2.0 | 1.9 | 2.1 | 1.9 | 1.6 | 1.6 | 1.7 | 1.6 |
| Residues after development | BB | BB | BB | BB | BB | AA | AA | AA | AA |
| Condensation of light-receiving | AA | BB | AA | BB | AA | AA | AA | AA | AA |
| device | | | | | | | | | |
| Reliability of light-receiving | AA | AA | AA | AA | AA | AA | AA | AA | AA |
| device | | | | | | | | | |

[TABLE 2]

| | Ex. 10 | Ex.11 | Ex.12 | Ex. 13 | Ex. 14 | Ex. 15 | Ex.16 | Ex. 17 | Ex. 18 |
|---|---|---|---|---|---|---|---|---|---|
| MPN001 | 40.0 | 40.0 | 40.0 | 40.0 | 40.0 | 40.0 | 40.0 | 40.0 | 40.0 |
| IRGACURE 651 | 3.0 | 3.0 | 3.0 | 3.0 | 3.0 | 3.0 | 3.0 | 3.0 | 3.0 |
| 3,4-dihydroxybenzoic acid | 2.0 | | | | | | | | |
| 3-hydroxy-p-toluic acid | | 2.0 | | | | | | | |

(continued)

| | Ex. 10 | Ex.11 | Ex.12 | Ex. 13 | Ex. 14 | Ex. 15 | Ex.16 | Ex. 17 | Ex. 18 |
|---|---|---|---|---|---|---|---|---|---|
| 3,4-dihydroxymandelic acid | | | 2.0 | | | | | | |
| 3-phenylsalicylic acid | | | | 2.0 | | | | | |
| 4-hydroxyphenylacetic acid | | | | | 2.0 | | | | |
| 3,4-dihydroxyphenylacetic acid | | | | | | 2.0 | | | |
| 2-(4-hydroxyphenyl)propionic acid | | | | | | | 2.0 | | |
| 3-(4-hydroxyphenyl)propionic acid | | | | | | | | 2.0 | |
| 4-(4-hydroxyphenyl)benzoic acid | | | | | | | | | 2.0 |
| EP-1032H | 30.0 | 30.0 | 30.0 | 30.0 | 30.0 | 30.0 | 30.0 | 30.0 | 30.0 |
| BY16-115 | 5.0 | 5.0 | 5.0 | 5.0 | 5.0 | 5.0 | 5.0 | 5.0 | 5.0 |
| Epoxy ester 3002 M | 5.0 | 5.0 | 5.0 | 5.0 | 5.0 | 5.0 | 5.0 | 5.0 | 5.0 |
| Light ester TMP | 15.0 | 15.0 | 15.0 | 15.0 | 15.0 | 15.0 | 15.0 | 15.0 | 15.0 |
| Total | 100.0 | 100.0 | 100.0 | 100.0 | 100.0 | 100.0 | 100.0 | 100.0 | 100.0 |
| Moisture permeability ($g/m^2$/ 24h) | 21 | 21 | 21 | 21 | 21 | 21 | 21 | 21 | 21 |
| Moisture absorption ratio (%) | 1.6 | 1.6 | 1.6 | 1.6 | 1.6 | 1.6 | 1.6 | 1.6 | 1.6 |
| Residues after development | AA | AA | AA | AA | AA | AA | AA | AA | AA |
| Condensation of light-receiving device | AA | AA | AA | AA | AA | AA | AA | AA | AA |
| Reliability of | AA | AA | AA | AA | AA | AA | AA | AA | AA |
| light-receiving device | | | | | | | | | |

[TABLE 3]

| | Ex. 19 | Ex. 20 | Ex. 21 | Ex. 22 | Ex. 23 | Ex. 24 | Ex. 25 | Ex. 26 | Comp. Ex.1 |
|---|---|---|---|---|---|---|---|---|---|
| MPN001 | 40.0 | 40.0 | 40.0 | 40.0 | 40.0 | 40.0 | 40.0 | 40.0 | 40.0 |
| IRGACURE 651 | 3.0 | 3.0 | 3.0 | 3.0 | 3.0 | 3.0 | 3.0 | 3.0 | 3.0 |
| 4-(4-hydroxyphenoxy) benzoic acid | 2.0 | | | | | | | | |
| Methylene disalicylic acid | | 2.0 | | | | | | | |
| 4-(2-hydroxyethoxy) salicylic acid | | | 2.0 | | | | | | |
| 2,6-dihydroxy-4-methylbenzoic acid | | | | 2.0 | | | | | |
| 5-hydroxyisophthalic acid | | | | | 2.0 | | | | |
| 5,5'-thiodisalicylic acid | | | | | | 2.0 | | | |
| 2-hydroxy-5-sulfobenzoic acid | | | | | | | 2.0 | | |

(continued)

| | Ex. 19 | Ex. 20 | Ex. 21 | Ex. 22 | Ex. 23 | Ex. 24 | Ex. 25 | Ex. 26 | Comp. Ex.1 |
|---|---|---|---|---|---|---|---|---|---|
| 6-hydroxy-1-naphthoic acid | | | | | | | | 2.0 | |
| EP-1001 | | | | | | | | | 32.0 |
| EP-1032H | 30.0 | 30.0 | 30.0 | 30.0 | 30.0 | 30.0 | 30.0 | 30.0 | |
| BY16-115 | 5.0 | 5.0 | 5.0 | 5.0 | 5.0 | 5.0 | 5.0 | 5.0 | 5.0 |
| Epoxy ester 3002 M | 5.0 | 5.0 | 5.0 | 5.0 | 5.0 | 5.0 | 5.0 | 5.0 | 5.0 |
| Light ester TMP | 15.0 | 15.0 | 15.0 | 15.0 | 15.0 | 15.0 | 15.0 | 15.0 | 15.0 |
| Total | 100.0 | 100.0 | 100.0 | 100.0 | 100.0 | 100.0 | 100.0 | 100.0 | 100.0 |
| Moisture permeability ($g/m^2/24h$) | 21 | 21 | 21 | 21 | 21 | 21 | 21 | 21 | 14 |
| Moisture absorption ratio (%) | 1.6 | 1.6 | 1.6 | 1.6 | 1.6 | 1.6 | 1.6 | 1.6 | 2.8 |
| Residues of development | AA | AA | AA | AA | AA | AA | AA | AA | DD |
| Condensation of | AA | AA | AA | AA | AA | AA | AA | AA | DD |
| light-receiving device | | | | | | | | | |
| Light-receiving device | AA | AA | AA | AA | AA | AA | AA | AA | DD |
| reliability | | | | | | | | | |

As apparent from Tables 1 to 3, the adhesive films of Examples 1 to 26 exhibited superior moisture permeability, a low moisture absorption ratio and an excellent developing property. In addition, condensation and reliability of the light-receiving devices were excellent.

This application is based on Japanese patent application No. 2009-97696 filed on April 14, 2009, the entire content of which is incorporated hereinto by reference.

## Claims

1. A photosensitive resin composition comprising:

    an alkali soluble resin (A);
    a photopolymerization initiator (B); and
    a compound (C) having a phenolic hydroxyl group and a carboxyl group.

2. The photosensitive resin composition according to claim 1, wherein the compound (C) having a phenolic hydroxyl group and a carboxyl group comprises a compound represented by any one of general formulae (1) to (3).

[Chemical Formula 10]

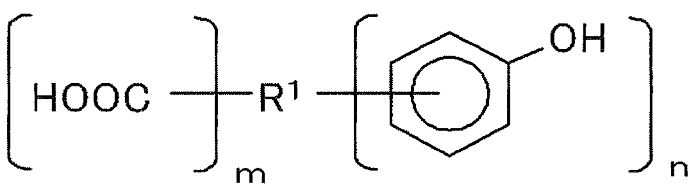

(1)

In formula (1), m and n are an integer of 1 to 3 and $R^1$ represents an organic group. In formula (1), an aromatic ring may have other substituent groups, in addition to a hydroxyl group.

[Chemical Formula 11]

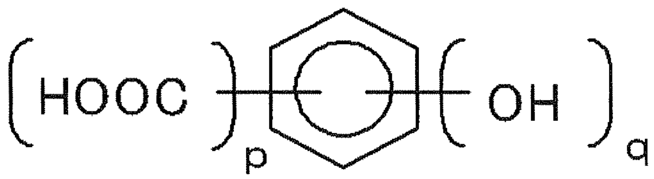

(2)

In formula (2), p and q are an integer of 1 to 5 under the condition that p+q=6. In formula (2), an aromatic ring may have other substituent groups, in addition to a hydroxyl group or a carboxyl group.

[Chemical Formula 12]

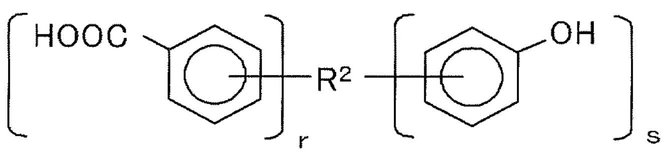

(3)

In formula (3), r and s are an integer of 1 to 3, and $R^2$ represents an organic group, a single bond, -O-, -S-, or $-SO_2-$. In formula (3), an aromatic ring may have other substituent groups, in addition to a hydroxyl group or a carboxyl group.

**3.** The photosensitive resin composition according to claim 1 or 2, wherein the compound (C) having a phenolic hydroxyl group and a carboxyl group has a weight-average molecular weight of 100 to 5000.

**4.** The photosensitive resin composition according to any one of claims 1 to 3, wherein the content of the compound (C) having a phenolic hydroxyl group and a carboxyl group is 0.1 to 30% by weight.

**5.** The photosensitive resin composition according to any one of claims 1 to 4, further comprising a thermosetting resin (D).

**6.** The photosensitive resin composition according to claim 5, wherein the content of the thermosetting resin (D) is 10 to 70% by weight.

**7.** The photosensitive resin composition according to claim 5 or 6, wherein the thermosetting resin (D) comprises an epoxy resin.

**8.** The photosensitive resin composition according to claim 7, wherein the epoxy resin is at least one selected from the group consisting of phenol novolac-type epoxy resins, cresol novolac-type epoxy resins, dicyclopentadiene-type epoxy resins and trisphenol methane-type epoxy resins.

**9.** The photosensitive resin composition according to any one of claims 1 to 8, further comprising a photopolymerizable compound (E) different from the alkali soluble resin (A).

**10.** The photosensitive resin composition according to any one of claims 1 to 9 wherein the alkali soluble resin (A) has an alkali soluble group and a double bond.

**11.** The photosensitive resin composition according to any one of claims 1 to 10 wherein the alkali soluble resin (A) is a (meth) acryloyl-modified phenol resin.

**12.** The photosensitive resin composition according to any one of claims 1 to 11 wherein the photosensitive resin composition is used for forming a spacer of a light-receiving device, wherein the light-receiving device comprises: a semiconductor device-mounted substrate; a transparent substrate located so as to face the semiconductor device-mounted substrate; and the spacer provided between the semiconductor device-mounted substrate and the transparent substrate.

**13.** An adhesive film made of the photosensitive resin composition according to any one of claims 1 to 11.

**14.** A light-receiving device comprising:

a semiconductor device-mounted substrate;
a transparent substrate located so as to face the semiconductor device-mounted substrate; and
a spacer provided between the semiconductor devices-mounted substrate and the transparent substrate, wherein the spacer is a cured material of the photosensitive resin composition according to any one of claims 1 to 11.

Fig.1

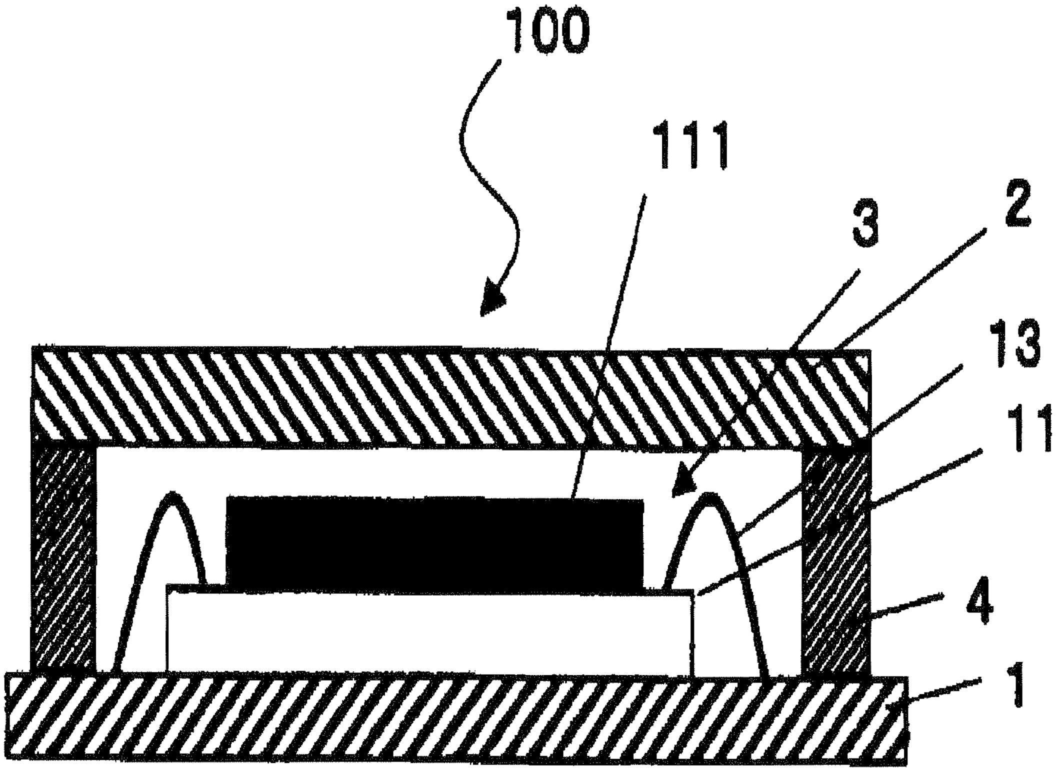

**INTERNATIONAL SEARCH REPORT**

International application No.
PCT/JP2010/002562

A. CLASSIFICATION OF SUBJECT MATTER
*G03F7/004*(2006.01)i, *G03F7/027*(2006.01)i, *H01L21/027*(2006.01)i

According to International Patent Classification (IPC) or to both national classification and IPC

B. FIELDS SEARCHED

Minimum documentation searched (classification system followed by classification symbols)
G03F7/004, G03F7/027, H01L21/027

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 2007-148371 A (Fujifilm Corp.),<br>14 June 2007 (14.06.2007),<br>example 8; paragraphs [0222], [0239]<br>& US 2007/099096 A1 & KR 2007047226 A<br>& TW 200722913 A | 1-11<br>12-14 |
| X<br>A | JP 2004-514159 A (Macdermid, Inc.),<br>13 May 2004 (13.05.2004),<br>example 1<br>& WO 2002/019035 A1 & AU 200181085 A<br>& EP 1323004 A1 & TW 588216 A | 1-4,9<br>5-8,10-14 |
| A | JP 2008-297540 A (Sumitomo Bakelite Co., Ltd.),<br>11 December 2008 (11.12.2008),<br>& WO 2008/0146936 A1 & JP 2009-009110 A<br>& TW 200907574 A | 1-14 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 28 April, 2010 (28.04.10) | 18 May, 2010 (18.05.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2010/002562

C (Continuation). DOCUMENTS CONSIDERED TO BE RELEVANT

| Category* | Citation of document, with indication, where appropriate, of the relevant passages | Relevant to claim No. |
|---|---|---|
| A | JP 10-186660 A (Tokyo Ohka Kogyo Co., Ltd.), 14 July 1998 (14.07.1998), & US 6042988 A & JP 3638743 B2 | 1-14 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006323089 A
- JP 2009097696 A